## Europäisches Patentamt

## European Patent Office

## Office européen des brevets

(11) Veröffentlichungsnummer: **0 146 749
B1**

(12) ## EUROPÄISCHE PATENTSCHRIFT

(45) Veröffentlichungstag der Patentschrift:
**18.10.89**

(21) Anmeldenummer: **84113453.9**

(22) Anmeldetag: **07.11.84**

(51) Int. Cl.⁴: **H 04 N 5/60**

(54) Verfahren und Schaltungsanordnung zur Feststellung des Vorhandenseins oder Nichtvorhandenseins mindestens einer Frequenz bekannten Wertes in einem aus mehreren Frequenzen zusammengesetzten Eingangssignal.

(30) Priorität: **08.11.83 DE 3340325**

(43) Veröffentlichungstag der Anmeldung:
**03.07.85 Patentblatt 85/27**

(45) Bekanntmachung des Hinweises auf die Patenterteilung:
**18.10.89 Patentblatt 89/42**

(84) Benannte Vertragsstaaten:
**DE FR GB IT NL**

(56) Entgegenhaltungen:
**DE-A- 2 800 242**

**FUNKSCHAU, Nr. 2, Januar 1982, München, (DE), Seiten 76-79; K.D. KüMMEL: "Zwei-Kanal-Fernsehton".**

(73) Patentinhaber: **Siemens Aktiengesellschaft,
Wittelsbacherplatz 2, D-8000 München 2 (DE)**

(72) Erfinder: **Stepp, Richard, Dipl.-Ing., Elisabethstrasse 25,
D-8000 München 40 (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die vorliegende Erfindung betrifft ein Verfahren und eine Schaltungsanordnung zur Feststellung des Vorhandenseins oder Nichtvorhandenseins mindestens einer Frequenz bekannten Wertes in einem aus mehreren Frequenzen zusammengesetzten Eingangssignal, bei dem zur Frequenzbestimmung eine stabile Referenzfrequenz verwendet wird.

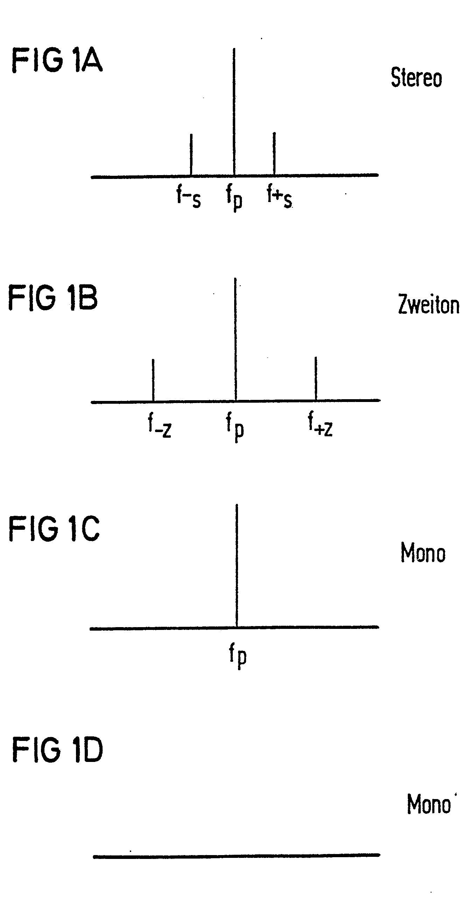

Ein Beispiel für die Notwendigkeit einer Feststellung des Vorhandenseins oder Nichtvorhandenseins bestimmter Frequenzen mit bekanntem Wert in einem aus mehreren Frequenzen zusammengesetzten Eingangssignal ist die Decodierung der Programmarterkennung im Zweiträger-Fernsehtonsystem. Einzelheiten dieses Zweiträger-Fernsehtonsystems sind in dem «CCIR-Dokument», Report 795-1 (1978–1982), Seiten 205 bis 213 beschrieben. Danach erfolgt die Programmarterkennung beim Zweiträger-Fernsehtonsystem mit Hilfe eines amplitudenmodulierten Pilotträgertones. Die Frequenz des Pilotträgertones ist gleich dem 3,5-fachen der Videozeilenfrequenz $f_H$. Für die Betriebsarten Stereo und Zweiton ist dem Pilotträgerton jeweils ein Kennton aufmoduliert. Die möglichen Betriebsarten sind in den Fig. 1 A bis 1 D jeweils in Form eines Frequenzspektrums dargestellt.

Fig. 1 A zeigt den Fall für die Betriebsart Stereo, bei der einem Pilottonträger, dessen Frequenz mit $f_p$ bezeichnet und die gleich $3,5 \cdot 15\,625$ Hz ist, durch Amplitudenmodulation ein Kennton mit einer Frequenz von 15 625/133 Hz aufmoduliert ist. Der Wert von 15 625 Hz ist dabei die Videozeilenfrequenz $f_H$. In Fig. 1 A sind die Seitenbänder mit $f_{+s}$ bzw. $f_{-s}$ bezeichnet.

Entsprechend zeigt die Fig. 1 B den Fall für die Betriebsart Zweiton, bei der dem Pilotträgerton der Frequenz $f_p$ ein Kennton mit der Frequenz 15 625/57 Hz aufmoduliert ist. Die Seitenbänder sind in diesem Fall mit $f_{+z}$ bzw. $f_{-z}$ bezeichnet.

Fig. 1 C zeigt die Betriebsart Mono im Zweiträger-Fernsehtonsystem, bei der lediglich der Pilotträgerton mit der Frequenz $f_p$ vorhanden ist, dem jedoch kein Kennton aufmoduliert ist.

Schließlich zeigt die Fig. 1 D die übliche Mono-Betriebsart bei der bisher üblichen Fernsehübertragung, bei welcher auch der Pilotträgerton nicht vorhanden ist.

Der Modulationsgrad bei den Betriebsart-Fällen nach den Fig. 1 A und 1 B beträgt 50%.

Die Übertragung der vorstehend erläuterten Amplitudenmodulations-Frequenzen erfolgt nun von einem Fernsehsender derart, daß der amplitudenmodulierte Pilotträgerton mittels Frequenzmodulation einem Träger im MHz-Bereich aufmoduliert wird. Im Fernsehempfänger wird zunächst eine Frequenz-Demodulation und danach eine Amplituden-Demodulation zur Gewinnung der Kenntöne durchgeführt. Die Auswertung der Information über die Betriebsarten Mono, Zweiton und Stereo kann über das obere oder untere Seitenband erfolgen. Die Auswertung der Seitenbänder ist dabei gleichwertig.

Bisher wurde die Decodierung der Programmarterkennung beim Zweiträger-Fernsehtonsystem durch Synchron- oder Hüllkurvengleichrichtung des modulierten Pilotträgertones mit anschließender Auswertung der demodulierten Kenntöne durchgeführt.

Bei der Übertragung von Fernsehinformation können aufgrund von Kreuzmodulationseffekten Störfrequenzen aus dem Videoanteil der Fernsehinformation entstehen, die mit der Frequenz des Pilotträgertones gleich sind. Diese Störfrequenzen können so stark sein, daß entsprechend starke Schwankungen der Pilotträger-Amplitude und damit unerwünschte Störfrequenzen nach der Amplituden-Demodulation auftreten.

Es ist speziell aus «Funkschau», Jan. 1982, No. 2, S. 76 bis 79 bekannt, für ein Zweiträger-Fernsehtonsystem einen automatisch umschaltbaren Stereo-Zweiton-Decoder vorzusehen, bei dem die für die Kennung notwendige Umschaltinformation mittels zweier gleichartiger PLL-Schaltungen gewonnen wird, die durch Potentiometer auf die jeweilige Kennfrequenz abgestimmt sind.

Der vorliegenden Erfindung liegt die Aufgabe zugrunde, eine Möglichkeit zur Feststellung des Vorhandenseins oder Nichtvorhandenseins von Frequenzen bekannten Wertes, insbesondere der vorstehend erläuterten Kenntöne im Zweiträger-Fernsehtonsystem anzugeben, bei der Trägerstörungen keine Rolle spielen.

Diese Aufgabe wird bei einem Verfahren der eingangs genannten Art erfindungsgemäß durch die Merkmale des kennzeichnenden Teils des Patentanspruchs 1 gelöst.

Eine Schaltungsanordnung zur Durchführung eines derartigen Verfahrens ist durch die Merkmale des Patentanspruchs 10 gekennzeichnet.

Weiterbildungen sowohl hinsichtlich des erfindungsgemäßen Verfahrens als auch der Schaltungsanordnung zur Durchführung eines derartigen Verfahrens sind in entsprechenden abhängigen Ansprüchen gekennzeichnet.

Die Erfindung wird im folgenden anhand von in den Fig. 2 bis 4 der Zeichnung näher erläutert. Es zeigt:

Fig. 2 ein Blockschaltbild einer erfindungsgemäßen Schaltungsanordnung;

Fig. 3 ein Blockschaltbild einer Ausführungsform eines in der Schaltungsanordnung nach Fig. 2 vorgesehenen Frequenzgenerators; und

Fig. 4 A und 4 B jeweils ein Diagramm zur Erläuterung der Auswertung von einer zu erkennenden Frequenz entsprechenden Gleichspannungsanteilen.

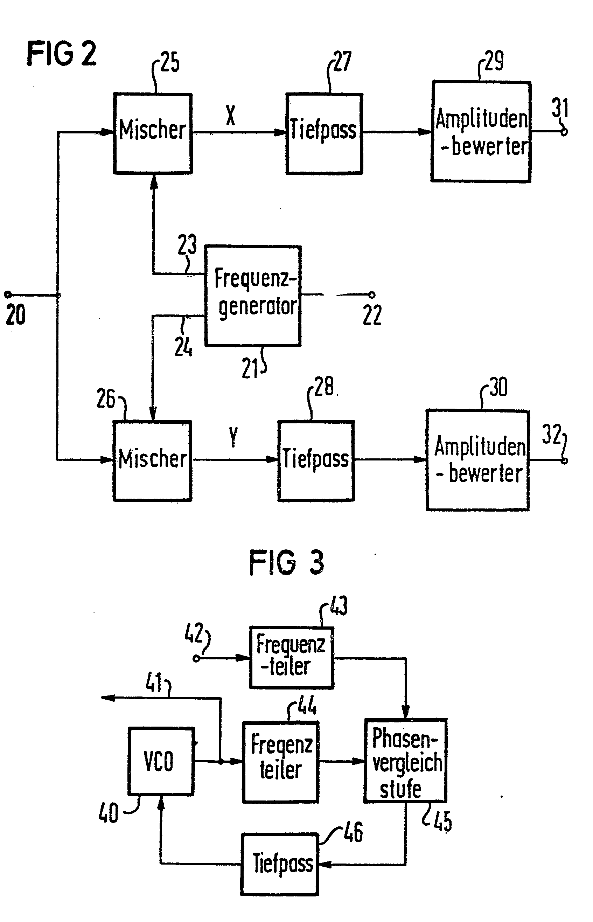

Bei der Schaltungsanordnung nach Fig. 2 wird ein Eingangssignal, in dem das Vorhandensein oder Nichtvorhandensein einer Frequenz bekannten Wertes festgestellt werden soll, in einen Eingang 20 eingespeist. Dieses Eingangssignal sei der Einfachheit halber mit

$$A \sin (\omega t + \varphi)$$

bezeichnet, worin

A die Amplitude
ω die Frequenz
t die Zeit, und
φ die Phase

bedeuten.

Mittels eines Frequenzgenerators 21 werden aus einer stabilen Referenzfrequenz, welche in einen Eingang 22 eingespeist wird, zwei Schaltsignale mit einer der festzustellenden Frequenz gleichen Frequenz und einem Phasenunterschied von 90° erzeugt. Die stabile Referenzfrequenz ist für den Fall des Zweiträger-Fernsehtonsystems zweckmäßigerweise die im Videosignal zur Verfügung stehende Videozeilenfrequenz $f_H$. Allgemein kann jedoch als Referenzfrequenz jede andere stabile Frequenz verwendet werden, die beispielsweise durch einen (nicht dargestellten) quarzgesteuerten Oszillator erzeugt wird.

Das Eingangssignal am Eingang 20 wird in jeweils einen Eingang von zwei linearen Mischern 25 und 26 eingespeist. In jeweils einen weiteren Eingang der beiden Mischer 25 und 26 wird über eine Leitung 23 und 24 jeweils eines der beiden vom Frequenzgenerator 21 erzeugten Schaltsignale mit der der festzustellenden Frequenz gleichen Frequenz und einem Phasenunterschied von 90° eingespeist. In den Mischern erfolgt in an sich bekannter Weise eine multiplikative Mischung des Eingangssignals mit dem jeweiligen Schaltsignal. Sind die Frequenzen des Eingangssignals und der beiden Schaltsignale gleich, so liefern die Mischer an ihren Ausgängen nur noch jeweils einen Gleichspannungsanteil X bzw. Y, welche der Amplitude A und dem Phasenwinkel φ des Eingangssignals proportional sind.

Speziell gilt:

$$X \sim A \sin \varphi$$
$$Y \sim A \cos \varphi$$

Ersichtlich muß das Eingangssignal in zwei Kanälen mit einem Phasenunterschied der Schaltsignale für die Mischer von 90° bewertet werden, da die Phase φ des Eingangssignals beliebig, d.h., auch Null oder 90° (oder jeweils ein Vielfaches davon mit dem Faktor 180°) sein kann, so daß der Gleichspannungsanteil gemäß den beiden vorstehend genannten Formeln bei einer Bewertung in einem Kanal verschwinden könnte.

Den beiden Mischern 25 und 26 ist jeweils ein Filter in Form eines Tiefpasses 27 bzw. 28 nachgeschaltet, das zur Ausfilterung von Wechselanteilen im Ausgangssignal des jeweiligen Mischers 25 und 26 dient. Diese Tiefpässe 27 und 28 besitzen jeweils eine Eckfrequenz von einigen Hz, vorzugsweise von höchstens 2 Hz. Die Tiefpässe 27 und 28 wirken bezüglich des Signals am Eingang 20 wie ein Bandpaß mit der Mittenfrequenz gleich der Schaltfrequenz der beiden Schaltsignale auf den Leitungen 23 und 24 und einer Bandbreite gleich der doppelten Tiefpaß-Eckfrequenz. An den Ausgängen dieser Tiefpässe treten daher nur die Gleichspannungsanteile X und Y bei Gleichheit der Frequenz des Signals am Eingang 20 und der Schaltsignale auf den Leitungen 23 und 24 auf.

Die Ausgangssignale der Tiefpässe 27 und 28 werden in jeweils einen Amplitudenbewerter 29 und 30 eingespeist, mit denen die Amplitude des Gleichspannungsanteils X bzw. Y bewertet wird. Eine Auswertung der Amplitude zur Feststellung des Vorhandenseins oder Nichtvorhandenseins einer Frequenz bekannten Wertes im Eingangssignal am Eingang 20 reicht aus, da die Phase φ des Eingangssignals willkürlich ist.

Diese Amplitudenbewertung kann auf verschiedene Weise erfolgen:

Beispielsweise können die Amplitudenbewerter 29 und 30 als an sich bekannte Schwellwertschalter ausgebildet sein, welche feststellen, ob die Absolutwerte der Gleichspannungsanteile X und Y größer als eine vorgegebene Schwelle S sind. Diese Art der Amplitudenbewertung ist im Diagramm nach Fig. 4 A dargestellt. Der Gleichspannungsanteil ist dabei wiederum durch eine Amplitude A und einen Winkel φ gegeben, so daß dieser Gleichspannungsanteil durch einen Zeiger 50 gebildet ist, der abhängig von dem beliebigen Winkel φ auf einem Kreis 51 liegen kann. Die als Schwellwertschalter ausgebildeten Amplitudenbewerter 29 und 30 nach Fig. 2 sprechen jeweils auf einen Schwellwert S an, so daß sich für die Bewertung des Gleichspannungsanteils mit der Amplitude A und dem Winkel φ ein Quadrat 52 mit der Kantenlänge S entsprechend den Schwellwerten der Schwellwertschalter ergibt. Liegt der Zeiger für den Gleichspannungsanteil entsprechend der Amplitude A außerhalb des durch den Schwellwert S definierten Quadrates 52, so wird der Gleichspannungsanteil als Maß für das Vorhandensein der festzustellenden Frequenz im Eingangssignal am Eingang 20 nach Fig. 2 als gültig an Ausgängen 31 und 32 der Amplitudenbewerter 29 und 30 nach Fig. 2 ausgegeben.

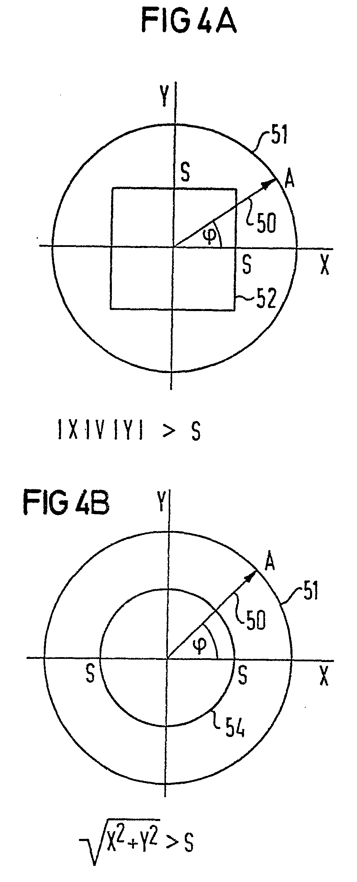

Eine weitere Möglichkeit der Bewertung der Gleichspannungsanteile X und Y besteht darin, die Quadratwurzel aus der Summe der Quadrate mittels konventioneller elektronischer Elemente zu ermitteln und festzustellen, ob der Wert dieser Wurzel größer als ein vorgegebener Schwellwert S ist. Dieser Sachverhalt ist im Diagramm nach Fig. 4 B dargestellt, das mit der Ausnahme dem Diagramm nach Fig. 4 A entspricht, daß sich aufgrund der Quadratwurzel aus der Summe der Quadrate der Werte X und Y anstelle des Bewerterquadrates 52 nach Fig. 4 A ein Bewerterkreis 54 ergibt.

Fig. 3 zeigt eine Ausführungsform zur Erzeugung der Schaltsignale für die Mischer 25 und 26 im Frequenzgenerator 21 nach Fig. 2 in Form einer PLL-Schaltung (Phase locked loop). Ein spannungsgesteuerter Oszillator 40 (VCO) schwingt dabei auf einer Frequenz des Schaltsignals für die Mischer 25, 26, wobei dessen Ausgangssignal über eine Leitung 41 ausgegeben wird, welche einer der Leitungen 23 bzw. 24 nach Fig. 4 entspricht. Die stabile Referenzfrequenz, die gemäß Fig. 2 in den Eingang 22 eingespeist wird, wird in der Schaltung nach Fig. 3 in den Eingang 42 eingespeist. Zur Frequenzanpassung ist dem Eingang 42 ein Frequenzteiler 43 und dem spannungsgesteuerten Oszillator 40 ein Frequenzteiler 44 nachgeschaltet. Die Ausgangssignale dieser Frequenzteiler 43 und 44 werden in einer Phasenvergleichsstufe 45 miteinander verglichen, wobei das Ausgangssignal der Phasenvergleichsstufe 45 über einen Tiefpaß 46 in den spannungsgesteuerten Oszillator 40 eingespeist wird, wodurch eine Frequenzregelung erfolgt.

Zur Erzeugung der beiden um 90° in der Phase verschobenen Schaltsignale auf den Leitungen 23 und 24 für die Mischer 25 und 26 kann die Ausgangsleitung 41 der PLL-Schaltung nach Fig. 3 aufgeteilt werden und in einer der aufgeteilten Leitungen ein Phasenschieber vorgesehen werden, welcher das Ausgangssignal um 90° in der Phase verschiebt. Da eine derartige Schaltungsmaßnahme an sich konventioneller Natur ist, ist sie in Fig. 3 nicht eigens dargestellt.

Für das Feststellen des Vorhandenseins oder Nichtvorhandenseins mehrerer Frequenzen bekannten Wertes, beispielsweise von unterschiedlichen Seitenbandfrequenzen nach den Fig. 1 A und B, kann eine Auswertung bzw. Decodierung in entsprechenden parallelen Kanälen erfolgen, wobei jeweils ein Kanal durch eine Schaltungsanordnung gemäß dem Ausführungsbeispiel nach Fig. 2 gebildet wird. Andererseits kann die Auswertung bzw. Decodierung jedoch auch im Multiplexbetrieb durch Umschaltung des Frequenzgenerators 21 nach Fig. 2 erfolgen, wobei dann die Schaltsignale auf den Leitungen 23 und 24 die der festzustellenden Frequenz im Eingangssignal entsprechende Frequenz besitzen.

Bei stark gestörten Eingangssignalen kann die Auswertung bzw. Decodierung durch an sich bekannte Verfahren der Störbefreiung, beispielsweise durch Integrationsverfahren oder durch statistische Auswertung verbessert werden.

## Patentansprüche

1. Verfahren zur Feststellung des Vorhandenseins oder Nichtvorhandenseins mindestens einer Frequenz bekannten Wertes in einem aus mehreren Frequenzen zusammengesetzten Eingangssignal, bei dem zur Frequenzbestimmung eine stabile Referenzfrequenz verwendet wird, dadurch gekennzeichnet,

daß aus der Referenzfrequenz zwei Schaltsignale mit einer der festzustellenden Frequenz gleichen Frequenz und einem Phasenunterschied von 90° erzeugt werden,

daß das Eingangssignal mit jedem der beiden Schaltsignale gemischt wird,

daß das jeweilige Mischprodukt zur Ausfilterung von darin enthaltenen Wechselanteilen einer Filterung unterworfen wird

und daß nach der Filterung eine Amplitudenbewertung eines bei Vorhandensein der Frequenz bekannten Wertes im jeweiligen Mischprodukt enthaltenen Gleichspannungsanteils durchgeführt wird.

2. Verfahren nach Anspruch 1 zur Feststellung von in einem Zweiträger-Fernsehtonsystem einem Pilottonträger aufmodulierten Kennfrequenzen, dadurch gekennzeichnet, daß als Referenzfrequenz die Videozeilenfrequenz verwendet wird und daß aus der Videozeilenfrequenz Schaltsignale mit einer den Kennfrequenzen gleichen Frequenz und einem Phasenunterschied von 90° erzeugt werden.

3. Verfahren nach Anspruch 1 und/oder 2, dadurch gekennzeichnet, daß die Ausfilterung von in den Mischprodukten enthaltenen Wechselanteilen mittels einer Tiefpaßfilterung durchgeführt wird.

4. Verfahren nach Anspruch 3, dadurch gekennzeichnet, daß die Tiefpaßfilterung mit einer Eckfrequenz von einigen Hz, vorzugsweise höchstens 2 Hz, durchgeführt wird.

5. Verfahren nach einem der Ansprüche 1 bis 4, dadurch gekennzeichnet, daß die Amplitudenbewertung dadurch erfolgt, daß die Absolutwerte des bei Vorhandensein der Frequenz bekannten Wertes im jeweiligen Mischprodukt enthaltenen Gleichspannungsanteils einer Schwellwertbestimmung unterworfen werden.

6. Verfahren nach einem der Ansprüche 1 bis 4, dadurch gekennzeichnet, daß die Amplitudenbewertung dadurch erfolgt, daß der Wert der Quadratwurzel der Summe der Quadrate der Absolutwerte des bei Vorhandensein der Frequenz bekannten Wertes im jeweiligen Mischprodukt enthaltenen Gleichspannungsanteils einer Schwellwertbestimmung unterworfen wird.

7. Verfahren nach einem der Ansprüche 1 bis 6, dadurch gekennzeichnet, daß die Feststellung mehrerer Frequenzen bekannten Wertes in parallelen Kanälen erfolgt, in denen die Schaltsignale jeweils die Frequenz einer festzustellenden Frequenz besitzen.

8. Verfahren nach einem der Ansprüche 1 bis 6, dadurch gekennzeichnet, daß die Feststellung mehrerer Frequenzen bekannten Wertes im Multiplexbetrieb durch Umschaltung der Schaltsignale auf die jeweilige festzustellende Frequenz erfolgt.

9. Verfahren nach einem der Ansprüche 1 bis 8, dadurch gekennzeichnet, daß zur Eliminierung von etwa vorhandenen Störungen eine Entstörung durch einen Integrationsprozeß oder eine statistische Auswertung durchgeführt wird.

10. Schaltungsanordnung zur Feststellung des Vorhandenseins oder Nichtvorhandenseins mindestens einer Frequenz bekannten Wertes in einem aus mehreren Frequenzen zusammengesetzten Eingangssignal mit einem eine stabile Referenzfrequenz aufnehmenden Eingang (22), gekennzeichnet durch einen von der stabilen Referenzfrequenz angesteuerten Frequenzgenerator (21) zur Erzeugung der Schaltsignale mit einen der festzustellenden Frequenz gleichen Frequenz und einem Phasenunterschied von 90°, jeweils einen an einen Ausgang des Frequenzgenerators (21) für ein Schaltsignal angekoppelten Mischer (25, 26) mit jeweils einem Eingang für das Eingangssignal, in dem das Vorhandensein oder Nichtvorhandensein mindestens einer Frequenz bekannten Wertes festgestellt werden soll, jeweils ein an den Ausgang jeweils eines Mischers (25, 26) angekoppeltes Filter (27, 28) zur Ausfilterung von Wechselanteilen in den Mischerausgangssignalen und jeweils eine an den Ausgang jeweils eines Filters (27, 28) angekoppelte Amplitudenbewerterstufe (29, 30).

11. Schaltungsanordnung nach Anspruch 10, gekennzeichnet durch einen quarzgesteuerten Oszillator zur Erzeugung der Referenzfrequenz.

12. Schaltungsanordnung nach Anspruch 10, dadurch gekennzeichnet, daß in einem Zweiträger-Fernsehtonsystem als Referenzfrequenz die Videozeilenfrequenz Verwendung findet.

13. Schaltungsanordnung nach einem der Ansprüche 10 bis 12, dadurch gekennzeichnet, daß der Frequenzgenerator (21) als PLL-Schaltung ausgebildet ist.

14. Schaltungsanordnung nach einem der Ansprüche 10 bis 13, dadurch gekennzeichnet, daß als Filter (27, 28) Tiefpässe mit einer Eckfrequenz von wenigen Hz, vorzugsweise höchstens 2 Hz, Verwendung finden.

15. Schaltungsanordnung nach einem der Ansprüche 10 bis 14, dadurch gekennzeichnet, daß als Amplitudenbewerterstufen (29, 30) Schwellwertschalter mit vorgegebener Schaltschwelle Verwendung finden.

16. Schaltungsanordnung nach einem der Ansprüche 10 bis 14, dadurch gekennzeichnet, daß als Amplitudenbewerterstufen (29, 30) Schaltungen Verwendung finden, welche die bei Vorhandensein der Frequenz bekannten Wertes an den Filterausgängen vorhandenen Gleichspannungsanteile zunächst quadrieren, die Quadrate addieren, aus der Summe der Quadrate die Quadratwurzel ziehen und die Quadratwurzel hinsichtlich einer vorgegebenen Schwelle bewerten.

17. Schaltungsanordnung nach einem der Ansprüche 10 bis 16, gekennzeichnet durch mehrere parallele Kanäle mit jeweils einem Frequenzgenerator (21) sowie von diesem angesteuerten Mischern (25, 26) mit nachgeschalteten Filtern (27, 28) und Amplitudenbewerterstufen (29, 30) für jeweils eine von mehreren festzustellenden Frequenzen bekannten Wertes.

18. Schaltungsanordnung nach einem der Ansprüche 10 bis 16, gekennzeichnet durch einen auf unterschiedliche Frequenzen umschaltbaren Frequenzgenerator (21) für mehrere festzustellende Frequenzen bekannten Wertes.

19. Schaltungsanordnung nach einem der Ansprüche 10 bis 18, gekennzeichnet durch Entstörkreise, beispielsweise Integratoren oder statistische Auswertekreise zur Elimination von im Eingangssignal enthaltenen Störungen.

## Claims

1. Method of determining the presence or absence of at least one frequency of a known value in an input signal composed of multiple frequencies, in which a stable reference frequency is used for frequency determination, characterized in that two switching signals having a frequency equal to the frequency to be determined and a phase difference of 90° are generated from the reference frequency, in that the input signal is mixed with each of the two switching signals, in that the respective mixed product is subjected to a filtering for the filtering-out of alternating components contained therein and in that, after the filtering, an amplitude assessment of a direct-voltage component contained in the respective mixed product in the presence of the frequency of a known value is carried out.

2. Method according to Claim 1 of determining characteristic frequencies modulated onto a pilot sound carrier in a two-carrier television sound system, characterized in that the video line frequency is used as reference frequency and in that switching signals having a frequency equal to the characteristic frequencies and a phase difference of 90° are generated from the video line frequency.

3. Method according to Claim 1 and/or 2, characterized in that the filtering-out of alternating components contained in the mixed products is carried out by means of a low-pass filtering.

4. Method according to Claim 3, characterized in that the low-pass filtering is carried out with a corner frequency of a few Hz, preferably at most 2 Hz.

5. Method according to one of Claims 1 to 4, characterized in that the amplitude assessment is performed by the absolute values of the direct-voltage component contained in the respective mixed product in the presence of the frequency of a known value being subjected to a threshold value determination.

6. Method according to one of Claims 1 to 4, characterized in that the amplitude assessment is performed by the value of the square root of the sum of the squares of the absolute values of the direct-voltage component contained in the respective mixed product in the presence of the frequency of a known value being subjected to a threshold value determination.

7. Method according to one of Claims 1 to 6, characterized in that the determining of multiple frequencies of a known value is performed in parallel channels, in which the switching signals have in each case the frequency of a frequency to be determined.

8. Method according to one of Claims 1 to 6, characterized in that the determining of multiple frequencies of a known value is performed in multiplex operation by switching of the switching frequencies to the respective frequency to be determined.

9. Method according to one of Claims 1 to 8, characterized in that, for eliminating any interferences which may be present, an interference suppression is carried out by an integration process or a statistical evaluation.

10. Circuit arrangement for determining the presence or absence of at least one frequency of a known value in an input signal composed of multiple frequencies, having an input (22) receiving a stable reference frequency, characterized by a frequency generator (21), for the generation of the switching signals, which is triggered by the stable reference frequency and has a frequency equal to the frequency to be determined and a phase difference of 90°, in each case a mixer (25, 26), which is coupled to an output of the frequency generator (21) for a switching signal, has in each case an input for the input signal and in which the presence or absence of at least one frequency of a known value is to be determined, in each case a filter (27, 28), for the filtering-out of alternating components in the mixer output signals, which is coupled to the output of in each case a mixer (25, 26), and in each case an amplitude assessor stage (29, 30), which is coupled to the output of in each case a filter (27, 28).

11. Circuit arrangement according to Claim 10, characterized by a quartz-controlled oscillator for the generation of the reference frequency.

12. Circuit arrangement according to Claim 10, characterized in that the video line frequency is used as reference frequency in a two-carrier television sound system.

13. Circuit arrangement according to one of Claims 10 to 12, characterized in that the frequency generator (21) is designed as a PLL circuit.

14. Circuit arrangement according to one of Claims 10 to 13, characterized in that low-pass filters having a corner frequency of a few Hz, preferably at most 2 Hz, are used as filter (27, 28).

15. Circuit arrangement according to one of Claims 10 to 14, characterized in that threshold value switches having a predetermined switching threshold are used as amplitude assessor stages (29, 30).

16. Circuit arrangement according to one of Claims 10 to 14, characterized in that circuits which, in the presence of the frequency of a known value, firstly square direct-voltage components present at the filter outputs, add the squares, take the square root from the sum of the squares and assess the square root with regard to a predetermined threshold are used as amplitude assessor stages (29, 30).

17. Circuit arrangement according to one of Claims 10 to 16, characterized by a plurality of parallel channels having in each case a frequency generator (21) and mixers (25, 26), triggered by the latter, with downstream filters (27, 28) and amplitude assessor stages (29, 30) for in each case one of multiple frequencies of a known value to be determined.

18. Circuit arrangement according to one of Claims 10 to 16, characterized by a frequency generator (21), which can be switched to different frequencies, for multiple frequencies of a known value to be determined.

19. Circuit arrangement according to one of Claims 10 to 18, characterized by interference suppression circuits, for example integrators or statistical evaluation circuits for the elimination of interferences contained in the input signal.

**Revendications**

1. Procédé pour déterminer la présence ou l'absence d'au moins une fréquence possédant une valeur connue dans un signal d'entrée composé de plusieurs fréquences, selon lequel, pour la détermination de la fréquence, on utilise une fréquence de référence stable, caractérisé par le fait qu'à partir de la fréquence de référence, on forme deux signaux de commutation possédant une fréquence égale à la fréquence devant être déterminée, et une différence de phase de 90°,

qu'on mélange le signal d'entrée avec chacun des deux signaux de commutation,

qu'on soumet à un filtrage le produit mixte respectif, de manière à éliminer par filtrage des composantes alternatives contenues dans ce produit, et

qu'après le filtrage, on réalise une évaluation de l'amplitude d'une composante de tension continue contenue dans le produit mixte respectif, lors de la présence d'une fréquence de valeur connue.

2. Procédé suivant la revendication 1, pour déterminer des fréquences caractéristiques modulant une porteuse son pilote dans un système sons de télévision à deux porteuses, caractérisé par le fait qu'on utilise, comme fréquence de référence, la fréquence des lignes vidéo et qu'on forme, à partir de la fréquence des lignes vidéo, des signaux de commutation possédant une fréquence égale aux fréquences caractéristiques et une différence de phase de 90°.

3. Procédé suivant la revendication 1 et/ou 2, caractérisé par le fait qu'on élimine par filtrage les composantes alternatives contenues dans les produits mixtes, à l'aide d'un filtrage passe-bas.

4. Procédé suivant la revendication 3, caractérisé par le fait que le filtrage passe-bas est exécuté avec une fréquence limite égale à quelques Hz et de préférence au maximum à 2 Hz.

5. Procédé suivant l'une des revendications 1 à 4, caractérisé par le fait qu'on évalue l'amplitude en comparant à une valeur de seuil les valeurs absolues de la composante de tension continue contenue dans le produit mixte respectif dans le cas de la présence de la fréquence de valeur connue.

6. Procédé suivant l'une des revendications 1 à 4, caractérisé par le fait qu'on évalue l'amplitude en comparant à une valeur de seuil, la racine carrée de la somme des carrés des valeurs absolues de la composante de tension continue contenue dans le produit mixte respectif dans le cas de la présence de la fréquence de valeur connue.

7. Procédé suivant l'une des revendications 1 à 6, caractérisé par le fait que la détermination de plusieurs fréquences de valeur connue s'effectue dans des canaux parallèles, dans lesquels les signaux de commutation possèdent respectivement la fréquence ayant la valeur d'une fréquence devant être déterminée.

8. Procédé suivant l'une des revendications 1 à 6, caractérisé par le fait que la détermination de plusieurs fréquences de valeur connue est réalisée selon un fonctionnement multiplex, au moyen d'une commutation des signaux de commutation sur la fréquence respective devant être déterminée.

9. Procédé suivant l'une des revendications 1 à 8, caractérisé par le fait que pour éliminer d'éventuels parasites éventuellement présents, on exécute un antiparasitage en mettant en œuvre un

procédé d'intégration ou une évaluation statistique.

10. Montage pour déterminer la présence ou l'absence d'au moins une fréquence de valeur connue dans un signal d'entrée composé de plusieurs fréquences, comportant une entrée (22) recevant une fréquence de référence stable, caractérisé par

un générateur de fréquences (21) commandé par la fréquence de référence stable et servant à produire les signaux de commutation possédant une fréquence égale à la fréquence devant être déterminée, et une différence de phase de 90°, un mélangeur (25, 26) accouplé à une sortie du générateur de fréquences (21) pour un signal de commutation et possédant respectivement une entrée pour le signal d'entrée, dans lequel la présence ou l'absence d'au moins une fréquence de valeur connue doit être déterminée,

un filtre respectif (27, 28) accouplé à la sortie de chaque mélangeur (25, 26) et servant à éliminer par filtrage des composantes alternatives présentes dans les signaux de sortie du mélangeur, et un étage respectif (29, 30) d'évaluation de l'amplitude, accouplé à la sortie de chaque filtre (27, 28).

11. Montage suivant la revendication 10, caractérisé par un oscillateur piloté par quartz, servant à produire la fréquence de référence.

12. Montage suivant la revendication 10, caractérisé par le fait qu'on utilise la fréquence des lignes vidéo comme fréquence de référence dans un système sons de télévision à deux porteuses.

13. Montage suivant l'une des revendications 10 à 12, caractérisé par le fait que le générateur de fréquences (21) est réalisé sous la forme d'un circuit PLL.

14. Montage suivant l'une des revendications 10 à 13, caractérisé par le fait qu'on utilise, comme filtres (27, 28), des filtres passe-bas possédant une fréquence limite égale à quelques Hz et de préférence au maximum à 2 Hz.

15. Montage suivant l'une des revendications 10 à 14, caractérisé par le fait qu'on utilise, comme étages (29, 30) d'évaluation de l'amplitude, des commutateurs à valeur de seuil possédant un seuil de commutation prédéterminé.

16. Montage suivant l'une des revendications 10 à 14, caractérisé par le fait qu'on utilise, comme étages (29, 30) d'évaluation de l'amplitude, des circuits, qui tout d'abord élèvent au carré les composantes de tension continue présentes au niveau des sorties des filtres dans le cas de la présence de la fréquence de valeur connue, additionnent les carrés, forment la racine carrée de la somme des carrés et évaluent la racine carrée par rapport à un seuil prédéterminé.

17. Montage suivant l'une des revendications 10 à 16, caractérisé par plusieurs canaux parallèles comportant chacun un générateur de fréquences (21) ainsi que des mélangeurs (25, 26), qui sont commandés par ce générateur et en aval duquel sont branchés des filtres (27, 28) et des étages (29, 30) d'évaluation de l'amplitude, respectivement pour l'une de plusieurs fréquences devant être déterminées et possédant des valeurs connues.

18. Montage suivant l'une des revendications 10 à 16, caractérisé par un générateur de fréquences (21) pouvant être commuté sur des fréquences différentes et prévu pour plusieurs fréquences devant être déterminées et possédant des valeurs connues.

19. Montage suivant l'une des revendications 10 à 18, caractérisé par des circuits d'antiparasitage, par exemple des intégrateurs ou des circuits d'évaluation statistique, servant à supprimer des parasites contenus dans le signal d'entrée.

FIG 1A

Stereo

$$f_{-s} \quad f_p \quad f_{+s}$$

FIG 1B

Zweiton

$$f_{-z} \quad f_p \quad f_{+z}$$

FIG 1C

Mono

$$f_p$$

FIG 1D

Mono

# FIG 2

# FIG 3

# FIG 4A

$$|X| \vee |Y| > S$$

# FIG 4B

$$\sqrt{X^2 + Y^2} > S$$